# EUROPEAN PATENT APPLICATION

(11) **EP 4 742 870 A1**
(43) Date of publication of application: **13.05.2026**
(21) Application number: 24836139.6
(22) Date of filing: 24.01.2024
(51) Int. Cl.: H10K 59/126, H10K 59/122, H10K 59/80, H10K 59/121, H10D 30/67, H10K 59/123

(54) **DISPLAY DEVICE**

(30) Priority: 06.07.2023 KR 20230087723
(71) Applicant: Samsung Display Co., Ltd., Yongin-si, Gyeonggi-do 17113 (KR)
(72) Inventor: SHIN, Jae Min, Yongin-si Gyeonggi-do 17113 (KR); YOON, Joo Sun, Yongin-si Gyeonggi-do 17113 (KR)
(74) Representative: Marks & Clerk LLP
(86) International application number: PCT/KR2024/001110
(87) International publication number: WO 2025/009685

(57) **Abstract**

A display device according to an embodiment comprises: a substrate which includes a display area and a non-display area; a light-emitting element layer which is disposed on the display area and includes a pixel electrode, an organic light-emitting layer, and a common electrode; a circuit unit which is disposed on the non-display area and includes a plurality of circuit transistors; and a pixel-defining layer which extends from the display area to the circuit unit, wherein the pixel-defining layer includes a plurality of openings overlapping the circuit unit, and the plurality of openings do not overlap the plurality of circuit transistors.

## Description

### [TECHNICAL FIELD]

The present disclosure relates to a display device.

### [BACKGROUND ART]

As the information society develops, demands for display devices for displaying images are increasing in various forms. For example, display devices are applied to various electronic devices such as smartphones, digital cameras, notebook computers, navigation devices, and smart televisions.

The display devices may be flat panel display devices such as liquid crystal display devices, field emission display devices, and light emitting display devices. The light emitting display devices may include an organic light emitting display device including an organic light emitting element, an inorganic light emitting display device including an inorganic light emitting element such as an inorganic semiconductor, and an ultra-small light emitting display device including an ultra-small light emitting element.

An organic light emitting element may include two electrodes facing each other and a light emitting layer interposed between them. The light emitting layer may receive electrons and holes from the two electrodes, recombine them to generate excitons, and emit light as the generated excitons change from an excited state to a ground state.

### [DISCLOSURE]

### [TECHNICAL PROBLEM]

Aspects of the present disclosure provide a display device which can prevent reliability defects of a circuit part caused by external light.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

### [TECHNICAL SOLUTION]

The first circuit part may comprise a plurality of first circuit transistors, and the common electrode overlaps the first circuit transistors.

The second circuit part may comprise (2-1)th circuit transistors adjacent to the first circuit part and (2-2)th circuit transistors disposed adjacent to an outer side of the substrate from the (2-1)th circuit transistors, and the common electrode overlaps the (2-1)th circuit transistors and may not overlap the (2-2)th circuit transistors.

The openings may overlap at least some of the first circuit transistors and overlap at least some of the (2-1)-th circuit transistors.

The openings may not overlap the (2-2)th circuit transistors.

According to an aspect of the present disclosure, a display device comprises a substrate comprising a display area and a non-display area, a light emitting element layer disposed on the display area and comprising a pixel electrode, an organic light emitting layer and a common electrode, circuit parts disposed on the non-display area and comprising a plurality of circuit transistors, and a pixel defining layer extending from the display area to the circuit parts and comprising a plurality of openings overlapping the circuit parts, wherein the openings overlap at least some of the circuit transistors and do not overlap the other circuit transistors.

The circuit parts may comprise a first circuit part disposed adjacent to the display area and a second circuit part spaced farther apart from the display area than the first circuit part, wherein each of the first circuit part and the second circuit part may comprise at least buffer transistors, and the buffer transistors may not overlap the openings.

Each of the first circuit part and the second circuit part may further comprise switching transistors, and at least some of the switching transistors may overlap the openings, and the other switching transistors may overlap the pixel defining layer.

The common electrode may extend from the display area to the circuit parts, may overlap the first circuit part and the second circuit part, the buffer transistors disposed in the first circuit part may overlap the common electrode, and at least some of the buffer transistors disposed in the second circuit part may not overlap the common electrode.

The circuit transistors may comprise an oxide semiconductor.

The display device may further comprise a via layer disposed between the substrate and the pixel defining layer and covering the circuit transistors, and a connection line disposed between the pixel defining layer and the via layer and overlapping the circuit transistors.

The display device may further comprise a thin-film encapsulation layer disposed on the light emitting element layer and extending from the display area to the non-display area, wherein the thin-film encapsulation layer may overlap the circuit transistors.

Other features and embodiments may be apparent from the following detailed description and the drawings.

### [ADVANTAGEOUS EFFECTS]

In a display device according to an embodiment, openings of a pixel defining layer do not overlap circuit transistors disposed in a circuit part in a non-display area. Therefore, the circuit transistors can be prevented from being deteriorated by external light.

In addition, circuit transistors overlapping a common electrode in the non-display area overlap the openings, and circuit transistors not overlapping the common electrode do not overlap the openings. Therefore, the circuit transistors can be prevented from being deteriorated by external light.

In addition, the openings of the pixel defining layer do not overlap buffer transistors among the circuit transistors disposed in the circuit part in the non-display area. Therefore, the buffer transistors can be prevented from being deteriorated by external light.

The effects according to the embodiments are not limited by the contents exemplified above, and more various effects are included in this disclosure.

### [DESCRIPTION OF DRAWINGS]

FIG. 1 is a plan view of a display device according to an embodiment;
FIG. 2 is a cross-sectional view taken along line Q1-Q1' of FIG. 1;
FIG. 3 is a detailed plan view of an example of a display unit of FIG. 2;
FIG. 4 is an equivalent circuit diagram of a pixel of the display device according to the embodiment;
FIG. 5 is a cross-sectional view taken along line Q2-Q2' of FIG. 3;
FIG. 6 is an enlarged plan view of area A of FIG. 3;
FIG. 7 is a cross-sectional view taken along line Q3-Q3' of FIG. 6;
FIG. 8 is a cross-sectional view taken along line Q4-Q4' of FIG. 6;
FIG. 9 is a cross-sectional view taken along line Q5-Q5' of FIG. 6;
FIG. 10 is a plan view of a non-display area of a display device according to an embodiment;
FIG. 11 is a cross-sectional view taken along line Q6-Q6' of FIG. 10;
FIG. 12 is a cross-sectional view taken along line Q7-Q7' of FIG. 10;
FIG. 13 is a cross-sectional view taken along line Q8-Q8' of FIG. 10;
FIG. 14 is a plan view of a non-display area of a display device according to an embodiment; and
FIG. 15 is a cross-sectional view taken along line Q9-Q9' of FIG. 14.

### [MODES OF THE INVENTION]

The advantages and features of the present invention, and the methods for achieving them, will become apparent with reference to the embodiments described in detail below together with the accompanying drawings. However, the present invention is not limited to the embodiments disclosed hereinafter but will be embodied in various different forms, and these embodiments are merely provided so that the disclosure of the present invention is complete and to fully inform those skilled in the art to which the present invention pertains of the scope of the invention, and the present invention is defined by the scope of the claims.

When an element or a layer is referred to as being "on" another element or layer, this includes both a case where it is directly on the other element, and a case where another layer or element is interposed therebetween. Likewise, references to "below," "left," and "right" of another element also include both cases where they are directly adjacent and cases where another layer or material is interposed therebetween. Throughout the specification, the same reference numerals refer to the same components.

Although terms such as first, second, etc. are used to describe various components, these components are not limited by these terms. These terms are merely used to distinguish one component from another. Thus, a first component mentioned below may also be a second component within the technical spirit of the present invention.

Hereinafter, embodiments of the present disclosure will be described with reference to the drawings.

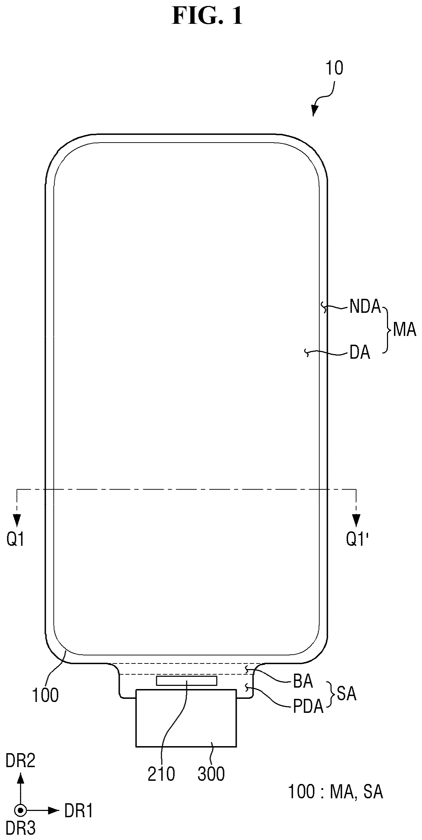

FIG. 1 is a plan view of a display device according to an embodiment.

In the present specification, "above," "top" and "upper surface" refer to an upward direction from the display device 10, that is, one direction in a third direction DR3, and "below," "bottom" and "lower surface" refer to the other direction in the third direction DR3. In addition, "left," "right," "upper," and "lower" refer to directions when the display device 10 is seen in plan view. For example, "right" refers to one direction in a first direction DR1, "left" refers to the other direction in the first direction DR1, "upper" refers to one direction in a second direction DR2, and "lower" refers to the other direction in the second direction DR2.

Referring to FIG. 1, the display device 10 is a device for displaying moving images or still images. The display device 10 may be used as a display screen in portable electronic devices such as mobile phones, smartphones, tablet personal computers (PCs), smart watches, watch phones, mobile communication terminals, electronic notebooks, electronic books, portable multimedia players (PMPs), navigation devices and ultra-mobile PCs (UMPCs), as well as in various products such as televisions, notebook computers, monitors, billboards and Internet of things (IoT) devices. The display device 10 may be any one of an organic light emitting display device, a liquid crystal display device, a plasma display device, a field emission display device, an electrophoretic display device, an electrowetting display device, a quantum dot light emitting display device, and a micro-light emitting diode display device. A case where the display device 10 is an organic light emitting display device will be mainly described below, but the present disclosure is not limited thereto.

The display device 10 according to the embodiment may include a display panel 100, a display driving circuit 210, and a circuit board 300.

The display panel 100 may include a main area MA and a sub-area SA protruding from a side of the main area MA.

The main area MA may be shaped like a rectangular plane having short sides in the first direction DR1 and long sides in the second direction DR2 intersecting the first direction DR1. Each corner where a short side extending in the first direction DR1 meets a long side extending in the second direction DR2 may be rounded with a predetermined curvature or may be right-angled. The planar shape of the display device 10 is not limited to a quadrilateral shape, but may also be another polygonal shape, a circular shape, or an oval shape. The main area MA may be formed to be flat. However, the present disclosure is not limited thereto, and the main area MA may also include curved portions formed at left and right ends thereof. In this case, the curved portions may have a constant curvature or a varying curvature.

The main area MA may include a display area DA where pixels are formed to display an image and a non-display area NDA located around the display area DA.

In the display area DA, not only pixels, but also scan lines, data lines and power lines connected to the pixels may be disposed. When the main area MA includes curved portions, the display area DA may be disposed in the curved portions. In this case, an image of the display panel 100 may also be seen in the curved portions.

The non-display area NDA may be defined as an area extending from the outside of the display area DA to edges of the display panel 100. A circuit part for transmitting scan signals and emission control signals and link lines connecting the data lines and the display driving circuit 210 may be disposed in the non-display area NDA.

The sub-area SA may protrude from a side of the main area MA. For example, the sub-area SA may protrude from a lower side of the main area MA as illustrated in FIG. 1. A length of the sub-area SA in the first direction DR1 may be smaller than a length of the main area MA in the first direction DR1.

The sub-area SA may include a bending area BA and a pad area PDA. In this case, the pad area PDA may be disposed on a side of the bending area BA, and the main area MA may be disposed on the other side of the bending area BA. For example, the pad area PDA may be disposed on a lower side of the bending area BA, and the main area MA may be disposed on an upper side of the bending area BA.

The display panel 100 may be formed to be flexible so that it can be curved, bent, folded, or rolled. Therefore, the display panel 100 can be bent in the bending area BA in the third direction DR3 which is a thickness direction. In this case, a surface of the pad area PDA of the display panel 100 faces upward before the display panel 100 is bent. However, after the display panel 100 is bent, the surface of the pad area PDA of the display panel 100 faces downward. Accordingly, the pad area PDA may be disposed under the main area MA and thus overlapped by the main area MA.

The display driving circuit 210 and pads electrically connected to the circuit board 300 may be disposed in the pad area PDA of the display panel 100.

The display driving circuit 210 outputs signals and voltages for driving the display panel 100. For example, the display driving circuit 210 may supply data voltages to the data lines. In addition, the display driving circuit 210 may supply power supply voltages to the power lines and supply scan control signals to the circuit part. The display driving circuit 210 may be formed as an integrated circuit and mounted on the pad area PDA of the display panel 100 using a chip on glass (COG) method, a chip on plastic (COP) method, or an ultrasonic bonding method. However, the present disclosure is not limited thereto. For example, the display driving circuit 210 may also be mounted on the circuit board 300.

The circuit board 300 may be attached onto the pads using an anisotropic conductive film. Therefore, lead lines of the circuit board 300 may be electrically connected to the pads. The circuit board 300 may be a flexible printed circuit board, a printed circuit board, or a flexible film such as a chip on film.

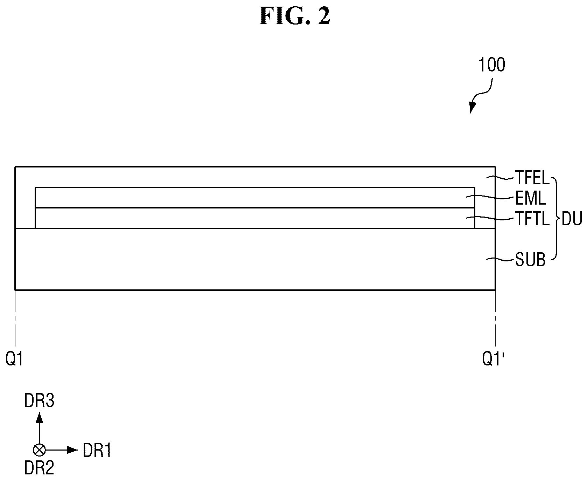

FIG. 2 is a cross-sectional view taken along line Q1-Q1' of FIG. 1.

Referring to FIG. 2, the display panel 100 may include a display unit DU including a substrate SUB, a thin-film transistor layer TFTL disposed on the substrate SUB, a light emitting element layer EML, and a thin-film encapsulation layer TFEL.

The substrate SUB may be made of an insulating material such as glass, quartz, or polymer resin. The polymer material may be, for example, polyethersulphone (PES), polyacrylate (PA), polyarylate (PAR), polyetherimide (PEI), polyethylene naphthalate (PEN), polyethylene terephthalate (PET), polyphenylene sulfide (PPS), polyallylate, polyimide (PI), polycarbonate (PC), cellulose triacetate (CAT), cellulose acetate propionate (CAP), or a combination thereof. Alternatively, the substrate SUB may include a metal material.

The substrate SUB may be a rigid substrate or a flexible substrate that can be bent, folded, or rolled. When the substrate SUB is a flexible substrate, it may be made of, but not limited to, polyimide (PI).

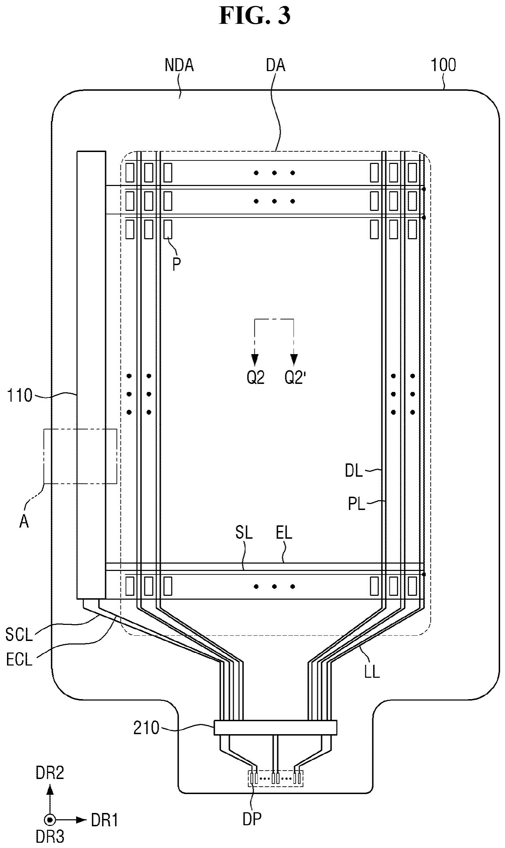

The thin-film transistor layer TFTL may be disposed on the substrate SUB. In the thin-film transistor layer TFTL, not only thin-film transistors of pixels, but also scan lines, data lines, power lines, scan control lines, and routing lines connecting pads and the data lines may be formed. Each of the thin-film transistors may include a gate electrode, a semiconductor layer, a source electrode, and a drain electrode. When a circuit part 110 (see FIG. 3) is formed in the non-display area NDA of the display panel 100 as illustrated in FIG. 3, it may include a plurality of thin-film transistors.

The thin-film transistor layer TFTL may be disposed in the display area DA and the non-display area NDA. Specifically, the thin-film transistors of the pixels, the scan lines, the data lines, and the power lines of the thin-film transistor layer TFTL may be disposed in the display area DA. Emission control lines, scan control lines and link lines of the thin-film transistor layer TFTL may be disposed in the non-display area NDA.

The light emitting element layer EML may be disposed on the thin-film transistor layer TFTL. The light emitting element layer EML may include pixels, each including a first electrode, a light emitting layer and a second electrode, and a pixel defining layer defining the pixels. The light emitting layer may be an organic light emitting layer including an organic material. In this case, the light emitting layer may include a hole transporting layer, an organic light emitting layer, and an electron transporting layer. When a predetermined voltage is applied to the first electrode and a cathode voltage is applied to the second electrode through a thin-film transistor of the thin-film transistor layer TFTL, holes and electrons move to the organic light emitting layer through the hole transporting layer and the electron transporting layer, respectively, and combine together in the organic light emitting layer to emit light. The pixels of the light emitting element layer EML may be disposed in the display area DA.

The thin-film encapsulation layer TFEL may be disposed on the light emitting element layer EML. The thin-film encapsulation layer TFEL prevents oxygen or moisture from permeating into the light emitting element layer EML. To this end, the thin-film encapsulation layer TFEL may include at least one inorganic layer. The inorganic layer may include, but is not limited to, silicon nitride (SiNx), silicon oxynitride (SiNxOy), silicon oxide (SiOx), titanium oxide (TiO₂), or aluminium oxide (Al₂O₃). In addition, the thin-film encapsulation layer TFEL protects the light emitting element layer EML from foreign substances such as dust. To this end, the thin-film encapsulation layer TFEL may include at least one organic layer. The organic layer may be, but is not limited to, acryl resin, epoxy resin, phenolic resin, polyamide resin, or polyimide resin.

The thin-film encapsulation layer TFEL may be disposed in both the display area DA and the non-display area NDA. Specifically, the thin-film encapsulation layer TFEL may cover the light emitting element layer EML of the display area DA and the non-display area NDA and cover the thin-film transistor layer TFTL of the non-display area NDA.

A touch sensor layer TSL may be disposed on the thin-film encapsulation layer TFEL. Since the touch sensor layer TSL is directly disposed on the thin-film encapsulation layer TFEL, a thickness of the display device 10 can be reduced as compared with when a separate touch panel including the touch sensor layer TSL is attached onto the thin-film encapsulation layer TFEL.

FIG. 3 is a detailed plan view of an example of the display unit of FIG. 2.

In FIG. 3, only pixels P, scan lines SL, data lines DL, power lines PL, an emission control line ECL, a scan control line SCL, the circuit part 110, the display driving circuit 210, and display pads DP are illustrated for ease of description.

Referring to FIG. 3, the scan lines SL, the data lines DL, the power lines PL, and the pixels P may be disposed in the display area DA. The scan lines SL may extend parallel to each other in the first direction DR1, and the data lines DL may extend parallel to each other in the second direction DR2 intersecting the first direction DR1. The power lines PL may include at least one line extending parallel to the data lines DL in the second direction DR2 and a plurality of lines branching from the at least one line in the first direction DR1.

Each of the pixels P may be connected to at least any one of the scan lines SL, any one of the data lines DL, and a power line PL. Each of the pixels P may include thin-film transistors including a driving transistor and at least one switching transistor, an organic light emitting diode, and a capacitor. Each of the pixels P may receive a data voltage of a data line DL in response to a scan signal transmitted from a scan line SL and supply a driving current to the organic light emitting diode according to the data voltage applied to a gate electrode, thereby emitting light.

The circuit part 110 is connected to the display driving circuit 210 through the scan control line SCL and the emission control line ECL. The circuit part 110 generates scan signals and emission signals in response to a scan control signal and an emission control signal received from the display driving circuit 210 and supplies the scan signals and the emission signals to the scan lines SL and emission lines EL.

Although the circuit part 110 is formed in the non-display area NDA outside a left side of the display area DA in FIG. 3, the present disclosure is not limited thereto. For example, the circuit part 110 may also be formed in the non-display area NDA outside left and right sides of the display area DA.

The display driving circuit 210 is connected to the display pads DP to receive digital video data and timing signals. The display driving circuit 210 converts the digital video data into analog positive/negative data voltages and supplies the analog positive/negative data voltages to the data lines DL through link lines LL. In addition, the display driving circuit 210 generates a scan control signal and an emission control signal for controlling the circuit part 110 and supplies the scan control signal and the emission control signal to the circuit part 110 through the scan control line SCL and the emission control line ECL. Pixels P to be supplied with the data voltages are selected by scan signals of the circuit part 110, and the data voltages are supplied to the selected pixels P. In addition, emission control voltages are supplied by emission nitride signals of the circuit part 110. The display driving circuit 210 may be formed as an integrated circuit and attached onto the substrate SUB using a COG method, a COP method, or an ultrasonic bonding method.

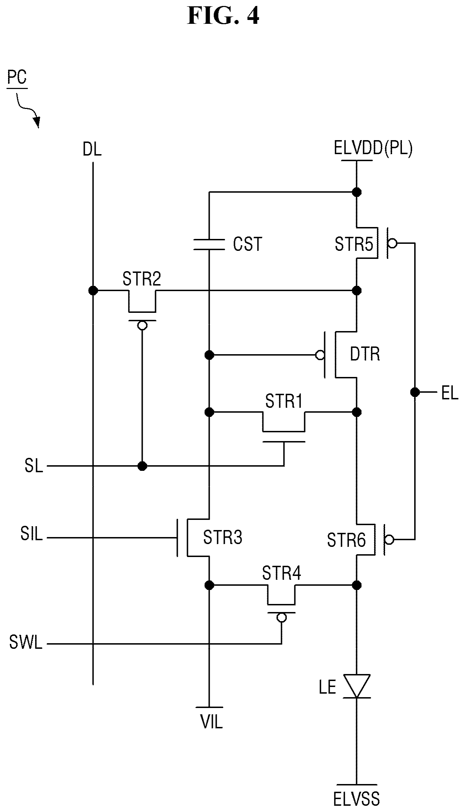

FIG. 4 is an equivalent circuit diagram of a pixel of the display device according to the embodiment.

Referring to FIG. 4, a pixel circuit PC may include a driving transistor DTR and first through sixth transistors STR1 through STR6. A first electrode of the driving transistor DTR may be electrically connected to a light emitting diode LE via the sixth transistor STR6. The driving transistor DTR receives a data signal according to a switching operation of the second transistor STR2 and supplies a driving current to the light emitting diode LE.

A gate electrode of the first transistor STR1 may be connected to a scan line SL. A first electrode of the first transistor STR1 may be connected to the first electrode of the driving transistor DTR and may be connected to a pixel electrode of the light emitting diode LE via the sixth transistor STR6. A second electrode of the first transistor STR1 may be connected to a first electrode of a capacitor CST, a first electrode of the third transistor STR3, and a gate electrode of the driving transistor DTR. The first transistor STR1 is turned on according to a scan signal received through the scan line SL and connects the gate electrode and drain electrode of the driving transistor DTR to each other to drive the driving transistor DTR.

A gate electrode of the second transistor STR2 is connected to the scan line SL, and a first electrode of the second transistor STR2 is connected to a data line DL. A second electrode of the second transistor STR2 may be connected to a second electrode of the driving transistor DTR and may be connected to a power line PL via the fifth transistor STR5. The second transistor STR2 is turned on according to the scan signal received through the scan line SL and performs a switching operation to transmit a data signal received through the data line DL to the second electrode of the driving transistor DTR.

A gate electrode of the third transistor STR3 may be connected to a scan initialization line SIL. A second electrode of the third transistor STR3 may be connected to an initialization voltage line VIL. The first electrode of the third transistor STR3 may be connected to the first electrode of the capacitor CST, the second electrode of the first transistor STR1, and the gate electrode of the driving transistor DTR. The third transistor STR3 may be turned on according to a scan initialization signal received through the scan initialization line SIL and may transmit an initialization voltage to the gate electrode of the driving transistor DTR to initialize the voltage of the gate electrode of the driving transistor DTR.

A gate electrode of the fourth transistor STR4 may be connected to a scan write line SWL. A first electrode of the fourth transistor STR4 may be connected to the pixel electrode of the light emitting diode LE. A second electrode of the fourth transistor STR4 may be connected to the initialization voltage line VIL. The fourth transistor STR4 may be turned on according to a scan write signal received through the scan write line SWL and may initialize the pixel electrode of the light emitting diode LE.

A gate electrode of the fifth transistor STR5 may be connected to an emission line EL. A first electrode of the fifth transistor STR5 may be connected to the power line PL. A second electrode of the fifth transistor STR5 is connected to the second electrode of the driving transistor DTR and the second electrode of the second transistor STR2.

A gate electrode of the sixth transistor STR6 may be connected to the emission line EL. A first electrode of the sixth transistor STR6 may be connected to the first electrode of the driving transistor DTR and the first electrode of the first transistor STR1. A second electrode of the sixth transistor STR6 may be electrically connected to the pixel electrode of the light emitting diode LE. The fifth transistor STR5 and the sixth transistor STR6 are simultaneously turned on according to an emission signal received through the emission line EL and allow a first power supply voltage ELVDD to be transmitted to the light emitting diode LE and a driving current to flow through the light emitting diode LE.

The first electrode of the capacitor CST may be connected to the gate electrode of the driving transistor DTR, the second electrode of the first transistor STR1, and the first electrode of the third transistor STR3.

A common electrode of the light emitting diode LE receives a second power supply voltage ELVSS. The light emitting diode LE emits light in response to a driving current received from the driving transistor DTR.

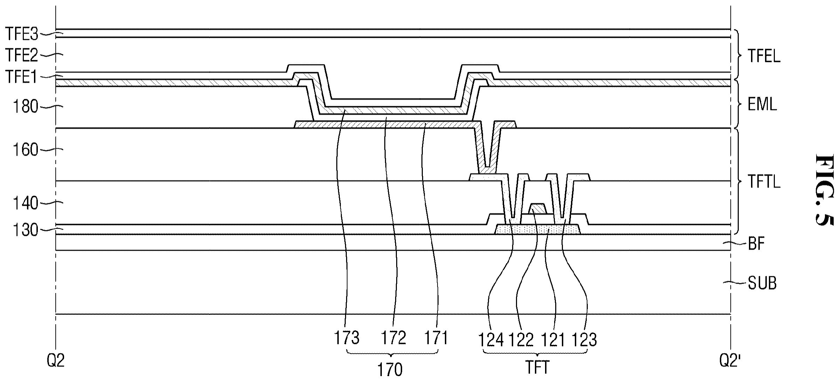

The pixel circuit PC described above is not limited to FIG. 5, and the number of transistors and capacitors and circuit design can be variously changed.

FIG. 5 is a cross-sectional view taken along line Q2-Q2' of FIG. 3.

Referring to FIG. 5, the thin-film transistor layer TFTL may be disposed on the substrate SUB. The thin-film transistor layer TFTL may include a transistor TFT, a gate insulating layer 130, an interlayer insulating layer 140, and a via layer 160.

Specifically, a buffer layer BF may be disposed on a surface of the substrate SUB. The buffer layer BF may be formed on the surface of the substrate SUB to protect the transistor TFT and an organic light emitting layer 172 of the light emitting element layer EML from moisture introduced through the substrate SUB which is vulnerable to moisture penetration. The buffer layer BF may be composed of a plurality of inorganic layers stacked alternately. For example, the buffer layer BF may be a multilayer in which one or more inorganic layers selected from silicon nitride (SiNx), silicon oxynitride (SiNxOy), silicon oxide (SiOx), titanium oxide (TiO₂), and aluminium oxide (Al₂O₃) are alternately stacked. However, the present disclosure is not limited thereto, and the buffer layer BF can also be omitted.

The transistor TFT may be disposed on the buffer layer BF. The transistor TFT may include an active layer 121, a gate electrode 122, a source electrode 123, and a drain electrode 124. In FIG. 5, the transistor TFT is formed in a top gate structure in which the gate electrode 122 is located above the active layer 121. However, the present disclosure is not limited thereto. The transistor TFT may also be formed in a bottom gate structure in which the gate electrode 122 is located below the active layer 121 or a double gate structure in which the gate electrode 122 is located both above and below the active layer 121.

The active layer 121 may be disposed on the buffer layer BF. The active layer 121 may include polycrystalline silicon, monocrystalline silicon, low-temperature polycrystalline silicon, amorphous silicon, or an oxide semiconductor. For example, the oxide semiconductor may include a binary compound (ABx), a ternary compound (ABxCy) or a quaternary compound (ABxCyDz) containing indium (In), zinc (Zn), gallium (Ga), tin (Sn), titanium (Ti), aluminium (Al), hafnium (Hf), zirconium (Zr), magnesium (Mg), etc. For example, the active layer 121 may include ITZO (an oxide including indium, tin, and zinc) or IGZO (an oxide including indium, gallium, and zinc). A light blocking layer may be further disposed between the buffer layer BF and the active layer 121 to block external light from entering the active layer 121.

The gate insulating layer 130 may be disposed on the active layer 121. The gate insulating layer 130 may include any one or more of silicon nitride (SiNx), silicon oxynitride (SiNxOy), silicon oxide (SiOx), titanium oxide (TiO₂), and aluminium oxide (Al₂O₃).

The gate electrode 122 may be disposed on the gate insulating layer 130. The gate electrode 122 may be a single layer or a multilayer made of any one or more of molybdenum (Mo), aluminium (Al), chromium (Cr), gold (Au), titanium (Ti), nickel (Ni), neodymium (Nd), copper (Cu), and alloys thereof. Although not illustrated, a scan line may be disposed on the same layer as the gate electrode 122.

The interlayer insulating layer 140 may be disposed on the gate electrode 122. The interlayer insulating layer 140 may include any one or more of silicon nitride (SiNx), silicon oxynitride (SiNxOy), silicon oxide (SiOx), titanium oxide (TiO₂), and aluminium oxide (Al₂O₃).

The source electrode 123 and the drain electrode 124 may be disposed on the interlayer insulating layer 140. Each of the source electrode 123 and the drain electrode 124 may be connected to the active layer 121 through a contact hole passing through the gate insulating layer 130 and the interlayer insulating layer 140. Each of the source electrode 123 and the drain electrode 124 may be a single layer or a multilayer made of any one or more of molybdenum (Mo), aluminium (Al), chromium (Cr), gold (Au), titanium (Ti), nickel (Ni), neodymium (Nd), copper (Cu), and alloys thereof.

The via layer 160 may be disposed on the source electrode 123 and the drain electrode 124 to flatten a step difference due to the transistor TFT. The via layer 160 may include acryl resin, epoxy resin, phenolic resin, polyamide resin, polyimide resin, or the like.

The light emitting element layer EML may be disposed on the thin-film transistor layer TFTL. The light emitting element layer EML may include a light emitting element 170 and a pixel defining layer 180.

The light emitting element 170 and the pixel defining layer 180 may be disposed on the via layer 160. The light emitting element 170 may include a pixel electrode 171, the organic light emitting layer 172, and a common electrode 173.

The pixel electrode 171 may be directly disposed on the via layer 160. The pixel electrode 171 may be connected to the source electrode 123 of the transistor TFT through a contact hole passing through the via layer 160.

In a top emission structure in which light is emitted from the organic light emitting layer 172 toward the common electrode 173, the pixel electrode 171 may be made of a metal material having high reflectivity, such as a stacked structure (Ti/Al/Ti) of aluminium and titanium, a stacked structure (ITO/AI/ITO) of aluminium and indium tin oxide, an APC alloy, or a stacked structure (ITO/APC/ITO) of an APC alloy and indium tin oxide. The APC alloy is an alloy of silver (Ag), palladium (Pd), and copper (Cu).

In a bottom emission structure in which light is emitted from the organic light emitting layer 172 toward the pixel electrode 171, the pixel electrode 171 may be made of a transparent conductive material (TCO) capable of transmitting light, such as indium tin oxide (ITO) or indium zinc oxide (IZO), or a semi-transmissive conductive material such as magnesium (Mg), silver (Ag) or an alloy of Mg and Ag. When the pixel electrode 171 is made of a semi-transmissive conductive material, light output efficiency may be increased by a microcavity.

The pixel defining layer 180 may define the pixel electrode 171 on the via layer 160 to define an emission area. The pixel defining layer 180 may be formed to cover edges of the pixel electrode 171. The pixel defining layer 180 may be made of an organic layer such as acryl resin, epoxy resin, phenolic resin, polyamide resin, or polyimide resin. In addition, the pixel defining layer 180 may include a black pigment or dye to reduce reflection of external light and prevent color mixing. For example, the pixel defining layer 180 may include carbon black.

The organic light emitting layer 172 may be disposed on the pixel electrode 171 and the pixel defining layer 180. The organic light emitting layer 172 may include an organic material to emit light of a predetermined color. For example, the organic light emitting layer 172 may include a hole transporting layer, an organic material layer, and an electron transporting layer. The organic light emitting layer 172 may emit red, green, or blue light. However, the present disclosure is not limited thereto, and the organic light emitting layer 172 may also emit white light.

The common electrode 173 may be disposed on the organic light emitting layer 172. The common electrode 173 may be formed to cover the organic light emitting layer 172. The common electrode 173 may be a common layer formed over the entire display area DA.

In the top emission structure, the common electrode 173 may be made of a transparent conductive material (TCO) capable of transmitting light, such as ITO or IZO, or a semi-transmissive conductive material such as magnesium (Mg), silver (Ag), or an alloy of magnesium (Mg) and silver (Ag). When the common electrode 173 is made of a semi-transmissive conductive material, light output efficiency may be increased by a microcavity.

In the bottom emission structure, the common electrode 173 may be made of a metal material having high reflectivity, such as a single layer of aluminium, a stacked structure (Ti/Al/Ti) of aluminium and titanium, a stacked structure (ITO/AI/ITO) of aluminium and indium tin oxide, an APC alloy, or a stacked structure (ITO/APC/ITO) of an APC alloy and indium tin oxide. The APC alloy is an alloy of silver (Ag), palladium (Pd), and copper (Cu).

The thin-film encapsulation layer TFEL may be disposed on the light emitting element layer EML. The thin-film encapsulation layer TFEL may be disposed on the common electrode 173. The thin-film encapsulation layer TFEL may include at least one inorganic layer to prevent permeation of oxygen or moisture into the organic light emitting layer 172 and the common electrode 173. In addition, the thin-film encapsulation layer TFEL may include at least one organic layer to protect the light emitting element layer EML from foreign substances such as dust.

The thin-film encapsulation layer TFEL may include a first encapsulation layer TFE1, a second encapsulation layer TFE2, and a third encapsulation layer TFE3. Each of the first encapsulation layer TFE1 and the third encapsulation layer TFE3 may be an inorganic layer. The inorganic layer may include, but is not limited to, silicon nitride (SiNx), silicon oxynitride (SiNxOy), silicon oxide (SiOx), titanium oxide (TiO₂), or aluminium oxide (Al₂O₃). The second encapsulation layer TFE2 may be an organic layer. The organic layer may include, but is not limited to, acryl resin, epoxy resin, phenolic resin, polyamide resin, or polyimide resin.

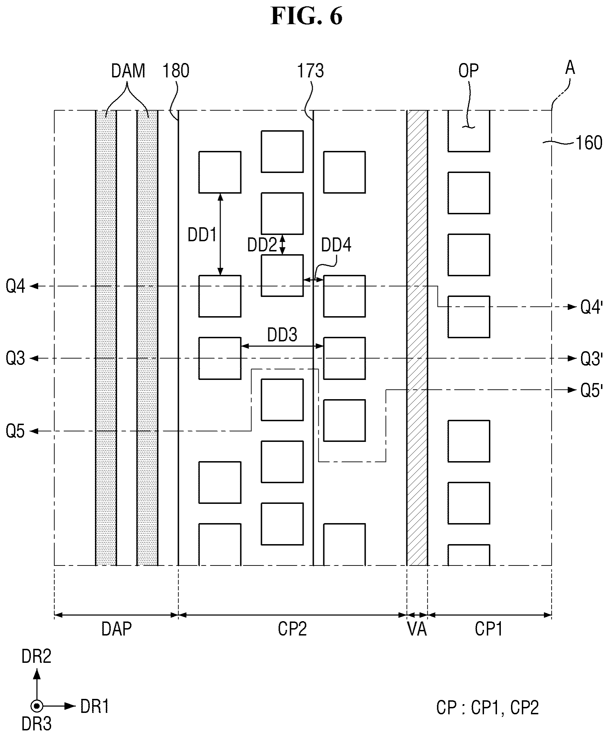

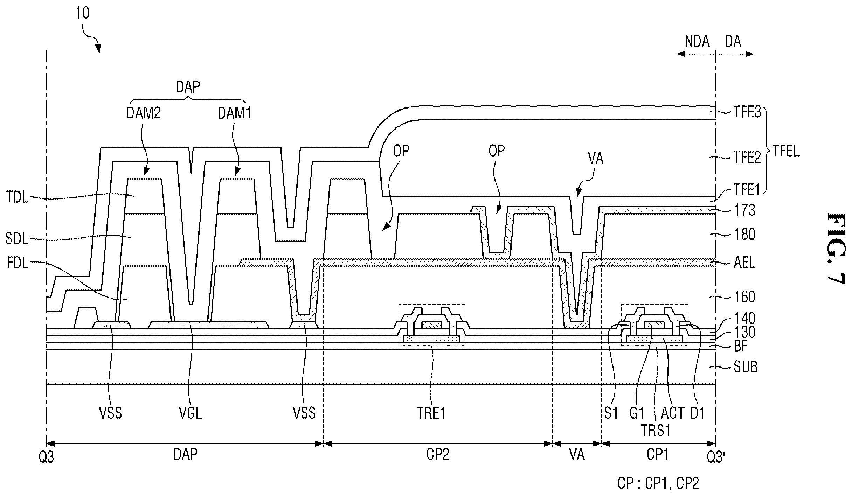

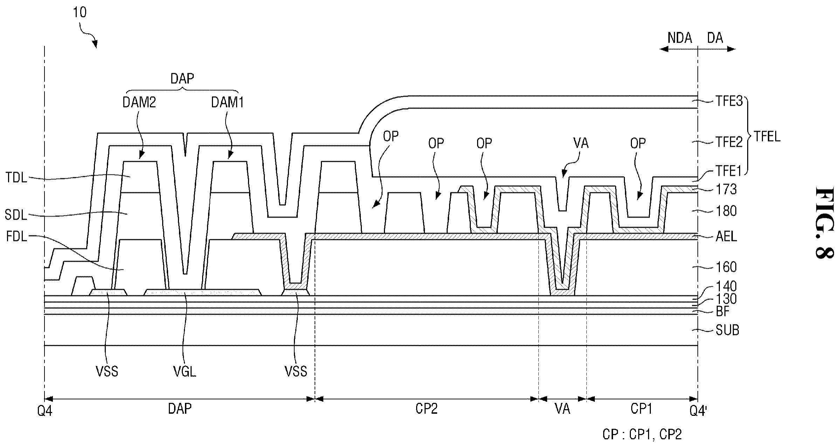

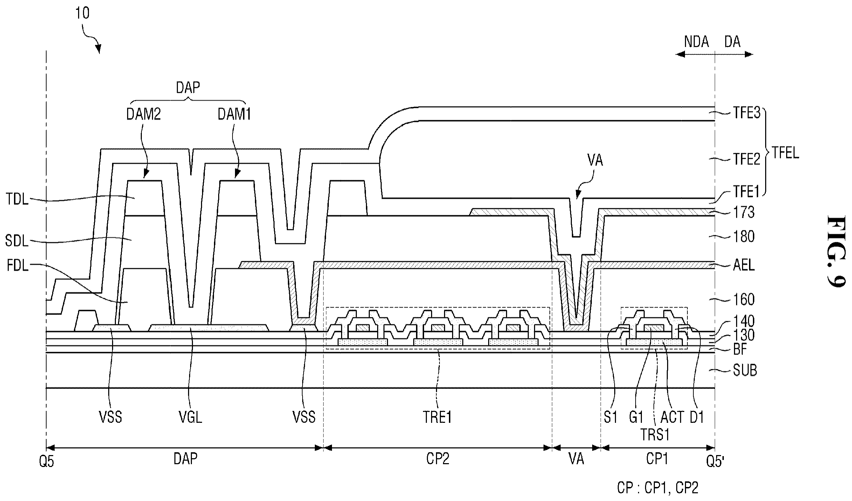

FIG. 6 is an enlarged plan view of area A of FIG. 3. FIG. 7 is a cross-sectional view taken along line Q3-Q3' of FIG. 6. FIG. 8 is a cross-sectional view taken along line Q4-Q4' of FIG. 6. FIG. 9 is a cross-sectional view taken along line Q5-Q5' of FIG. 6.

Referring to FIG. 6, the display device 10 may include the non-display area NDA. The non-display area NDA may include circuit parts CP and a dam part DAP and may include a groove part VA disposed between the circuit parts CP.

The circuit parts CP may be connected to the scan lines SL (see FIG. 3) and the emission control line ECL (see FIG. 3) to transmit signals to the display area DA. The circuit parts CP may be disposed adjacent to the display area DA and may extend in the second direction DR2. The circuit parts CP may include a first circuit part CP1 and a second circuit part CP2.

The first circuit part CP1 may be an area adjacent to the display area DA and may be disposed between the display area DA and the groove part VA. The first circuit part CP1 may include at least one transistor. In an embodiment, the first circuit part CP1 may transmit scan signals to the display area DA. The first circuit part CP1 may be connected to scan lines.

The second circuit part CP2 may be disposed in an area farther from the display area DA than the first circuit part CP1 and may be disposed between the groove part VA and the dam part DAP. The second circuit part CP2 may include at least one transistor. In an embodiment, the second circuit part CP2 may transmit emission control signals to the display area DA. The second circuit part CP2 may be connected to emission control lines.

The groove part VA may be disposed between the first circuit part CP1 and the second circuit part CP2. The groove part VA may separate the first circuit part CP1 and the second circuit part CP2 from each other. The groove part VA may be disposed in the non-display area NDA to surround the display area DA. In an embodiment, the groove part VA may be shaped like a closed loop completely surrounding the display area DA. The groove part VA may separate an organic insulating layer disposed in the non-display area NDA to block moisture that may permeate into the display area DA.

The dam part DAP may be disposed on an outermost side of the display device 10. The dam part DAP may surround the display area DA, together with the circuit parts CP. For example, the dam part DAP may be shaped like a closed loop completely surrounding the display area DA. The dam part DAP may prevent the second encapsulation layer TFE2 of the thin-film encapsulation layer TFEL (see FIG. 3) from overflowing to the outside. The dam part DAP may include at least one dam DAM.

The pixel defining layer 180 and the common electrode 173 extending from the display area DA may be disposed in the non-display area NDA. The pixel defining layer 180 may extend from the display area DA to the circuit parts CP of the non-display area NDA. The common electrode 173 may extend from the display area DA to a portion of the circuit parts CP of the non-display area NDA.

The pixel defining layer 180 described above may include an organic material. Due to the characteristics of the organic material, the organic material inside the pixel defining layer 180 may evaporate to generate a gas during a heat treatment process for manufacturing the display device 10. The gas generated inside the pixel defining layer 180 may weaken adhesion of layers formed on the pixel defining layer 180, thereby causing a peeling problem.

In the current embodiment, the pixel defining layer 180 may include a plurality of openings OP in the non-display area NDA. The openings OP may serve as passages through which the gas generated in the pixel defining layer 180 is released. The openings OP may be disposed in the circuit parts CP. For example, the openings OP may be disposed in the first circuit part CP1 and the second circuit part CP2. The openings OP may be arranged in rows and columns. For example, the openings OP may be spaced apart from each other in the first direction DR1 and the second direction DR2.

Meanwhile, a plurality of transistors may be disposed in the circuit parts CP. Each of the transistors may include an active layer including an oxide semiconductor. When the oxide semiconductor is irradiated with light, a threshold voltage of a transistor shifts in a negative direction. Specifically, when negative bias illumination stress (NBIS) is applied to the oxide semiconductor irradiated with light, holes are accumulated at an interface between a gate electrode and a channel. The holes accumulated at the interface are trapped or injected into an interface trap or a gate insulating layer to shift the threshold voltage in the negative direction. Therefore, even if the NBIS is removed, the negative shift of the threshold voltage cannot be restored to an original state, leading to deterioration of the oxide semiconductor. The deterioration of the oxide semiconductor may reduce driving reliability of the transistor and cause driving failure of the display device 10.

As described above, the black pixel defining layer 180 may have a plurality of openings OP formed on the circuit parts CP. Since the black pixel defining layer 180 does not exist in the openings OP, the openings OP may serve as incident paths of light from the outside. Accordingly, transistors of the circuit parts CP which overlap the openings OP may deteriorate.

The cross-sectional structure of the display device 10 which can improve driving reliability of the transistors of the circuit parts CP will now be described with reference to FIGS. 7 through 9 in addition to FIG. 6.

Referring to FIGS. 7 through 9, the circuit parts CP, the groove part VA, and the dam part DAP may be disposed on the substrate SUB in the non-display area NDA of the display device 10.

Specifically, the buffer layer BF may be disposed on the substrate SUB, and a first circuit transistor TRS1 and a second circuit transistor TRE1 may be disposed on the buffer layer BF. The first circuit transistor TRS1 may be disposed in the first circuit part CP1, and the second circuit transistor TRE1 may be disposed in the second circuit part CP2. The first circuit transistor TRS1 may be a transistor that transmits a scan signal, and the second circuit transistor TRE1 may be a transistor that transmits an emission control signal. Each of the first circuit transistor TRS1 and the second circuit transistor TRE1 may include an active layer ACT, a gate electrode G1, a source electrode S1, and a drain electrode D1. The active layer ACT may be disposed on the buffer layer BF, the gate electrode G1 may be disposed on the gate insulating layer 130, and the source electrode S1 and the drain electrode D1 may be disposed on the interlayer insulating layer 140. In the drawings, one first circuit transistor TRS1 is disposed in the first circuit part CP1, and three second circuit transistors TRE1 are disposed in the second circuit part CP2. However, the present disclosure is not limited thereto, and it may be understood that a plurality of circuit transistors are disposed in each of the circuit parts CP1 and CP2.

A second power line VSS and a scan signal line VGL may be disposed on the substrate SUB outside the circuit parts CP. The second power line VSS and the scan signal line VGL may be disposed on the interlayer insulating layer 140 and spaced apart from each other. The second power line VSS may be connected to the common electrode 173 of the display area DA, and the scan signal line VGL may be connected to the first circuit transistor TRS1 of the first circuit part CP1.

The via layer 160 may be disposed on the first circuit transistor TRS1, the second circuit transistor TRE1, the second power line VSS, and the scan signal line VGL. The via layer 160 may extend from the display area DA to the non-display area NDA. The via layer 160 may extend in the circuit parts CP and the dam part DAP.

A connection line AEL may be disposed on the via layer 160. The connection line AEL may extend from the display area DA to the non-display area NDA. The connection line AEL may include the same material as the pixel electrode 171 of the display area DA. The connection line AEL may extend to the second power line VSS of the non-display area NDA and may be electrically connected to the second power line VSS through contact holes formed in the via layer 160. The connection line AEL may electrically connect the second power line VSS and the common electrode 173. The connection line AEL may be disposed on the circuit parts CP and may overlap the circuit transistors TRS1 and TRE1.

The pixel defining layer 180 may be disposed on the via layer 160 and the connection line AEL. The pixel defining layer 180 may extend from the display area DA to the non-display area NDA. The pixel defining layer 180 may overlap the circuit parts CP. In an embodiment, the pixel defining layer 180 may overlap the first circuit part CP1 and the second circuit part CP2.

The groove part VA may be disposed between the first circuit part CP1 and the second circuit part CP2. The groove part VA may be formed in the via layer 160 and the pixel defining layer 180. For example, the groove part VA may pass through the via layer 160 and the pixel defining layer 180 to expose the interlayer insulating layer 140 thereunder. The groove part VA may separate the via layer 160 and the pixel defining layer 180 including an organic material to prevent moisture which may be introduced from the outside from permeating into the display area DA.

The common electrode 173 may be disposed on the pixel defining layer 180. The common electrode 173 may extend from the display area DA to the non-display area NDA. For example, the common electrode 173 may be disposed on the first circuit part CP1, the groove part VA, and the second circuit part CP2. The common electrode 173 may extend to at least a portion of the second circuit part CP2. The common electrode 173 may be electrically connected to the connection line AEL thereunder through an opening OP formed in the pixel defining layer 180. Therefore, the common electrode 173 may be electrically connected to the second power line VSS through the connection line AEL.

The dam part DAP may be disposed outside the circuit parts CP. The dam part DAP may include a first dam DAM1 and a second dam DAM2. In the current embodiment, the dam part DAP is illustrated and described as including two dams. However, the present disclosure is not limited thereto, and the dam part DAP may also include one dam or three or more dams. The first dam DAM1 and the second dam DAM2 may be spaced apart from each other to prevent the second encapsulation layer TFE2 of the thin-film encapsulation layer TFEL from overflowing from the display area DA to the outside.

Each of the first dam DAM1 and the second dam DAM2 may include a first layer FDL, a second layer SDL, and a third layer TDL. The first layer FDL may include the same material as the via layer 160, and the second layer SDL may include the same material as the pixel defining layer 180. The third layer TDL may include the same material as a spacer formed in the display area DA. Although not illustrated, the spacer may be a layer disposed on the pixel defining layer 180 of the display area DA and may support a mask during a mask process for forming the organic light emitting layer 172.

The thin-film encapsulation layer TFEL may be disposed on the pixel defining layer 180, the common electrode 173, and the dam part DAP. The thin-film encapsulation layer TFEL may extend from the display area DA to the non-display area NDA. The thin-film encapsulation layer TFEL may cover the circuit parts CP and overlap the circuit transistors TRS1 and TRE1 disposed in the circuit parts CP.

The first encapsulation layer TFE1 and the third encapsulation layer TFE3 may extend to the dam part DAP via the circuit parts CP. The first encapsulation layer TFE1 and the third encapsulation layer TFE3 may cover the dam part DAP to directly contact the interlayer insulating layer 140 on an outermost side of the substrate SUB. The second encapsulation layer TFE2 may be disposed on the circuit parts CP and the groove part VA. The second encapsulation layer TFE2 may not extend to the dam part DAP.

The pixel defining layer 180 may include a plurality of openings OP. The openings OP may be disposed in the circuit parts CP. For example, the openings OP may be disposed in the first circuit part CP1 and the second circuit part CP2.

The openings OP may be spaced apart from each other in the first direction DR1 and the second direction DR2 and may be repeatedly disposed in row and column directions. The openings OP may be irregularly disposed in plan view. For example, at least some of the openings OP may be disposed at equal intervals in the first direction DR1 and the second direction DR2 in plan view, and other openings OP may be disposed at different intervals in the first direction DR1 or the second direction DR2.

In an embodiment, a first distance DD1 measured in the second direction DR2 between two adjacent openings OP may be different from a second distance DD2 measured in the second direction DR2 between two other adjacent openings OP spaced apart from the above two adjacent openings OP in the first direction DR1. For example, the first distance DD1 measured in the second direction DR2 between two adjacent openings OP may be greater than the second distance DD2 measured in the second direction DR2 between two other adjacent openings OP spaced apart from the above two adjacent openings OP in the first direction DR1.

In addition, a third distance DD3 measured in the first direction DR1 between two adjacent openings OP may be different from a fourth distance DD4 measured in the first direction DR1 between two other adjacent openings OP spaced apart from the above two adjacent openings OP in the second direction DR2. For example, the third distance DD3 measured in the first direction DR2 between two adjacent openings OP may be greater than the fourth distance DD4 measured in the first direction DR1 between two other adjacent openings OP spaced apart from the above two adjacent openings in the second direction DR2.

In an embodiment, the openings OP may not overlap the transistors disposed in the circuit parts CP. Specifically, the openings OP may not overlap the first circuit transistor TRS1 disposed in the first circuit part CP1 and may not overlap the second circuit transistor TRE1 disposed in the second circuit part CP2. The first circuit transistor TRS1 and the second circuit transistor TRE1 may overlap the pixel defining layer 180.

As described above, the openings OP formed in the pixel defining layer 180 may serve as incident paths of external light. Therefore, if the openings OP overlap the first and second circuit transistors TRS1 and TRE1, the first and second circuit transistors TRS1 and TRE1 may be deteriorated by external light.

In the current embodiment, since the openings OP do not overlap the first circuit transistor TRS1 disposed in the first circuit part CP1 and do not overlap the second circuit transistor TRE1 disposed in the second circuit part CP2, deterioration of the circuit transistors due to external light can be prevented.

Display devices according to other embodiments will now be described with reference to other drawings.

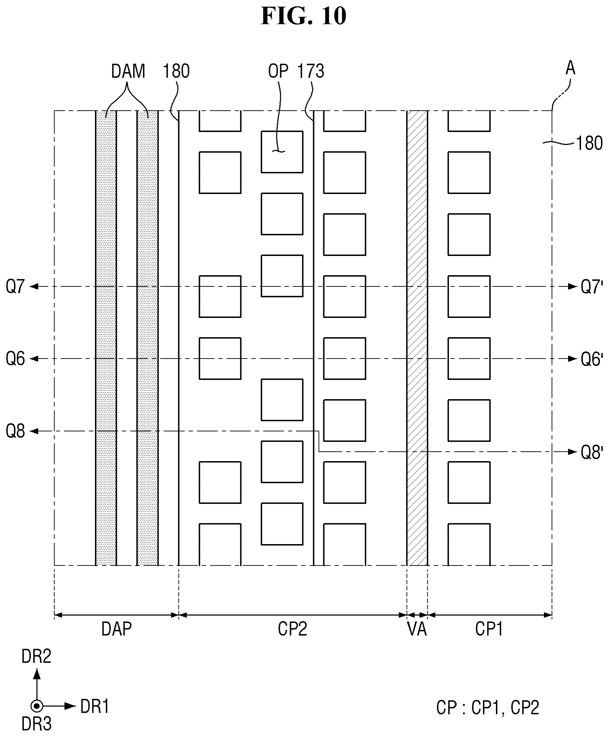

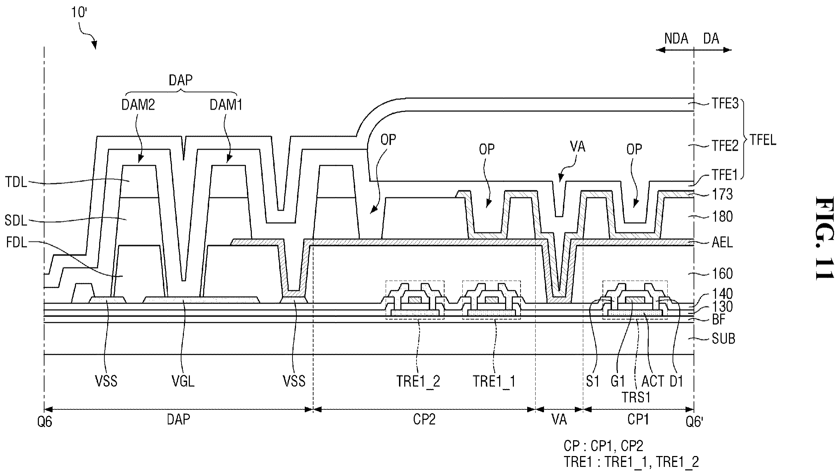

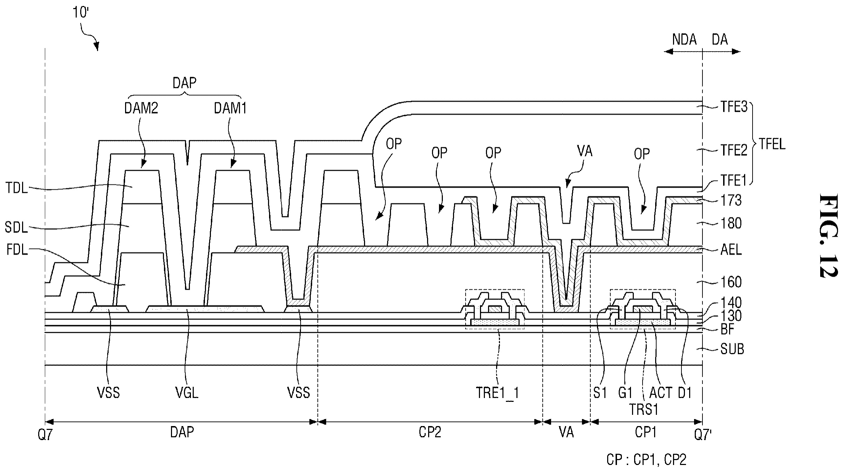

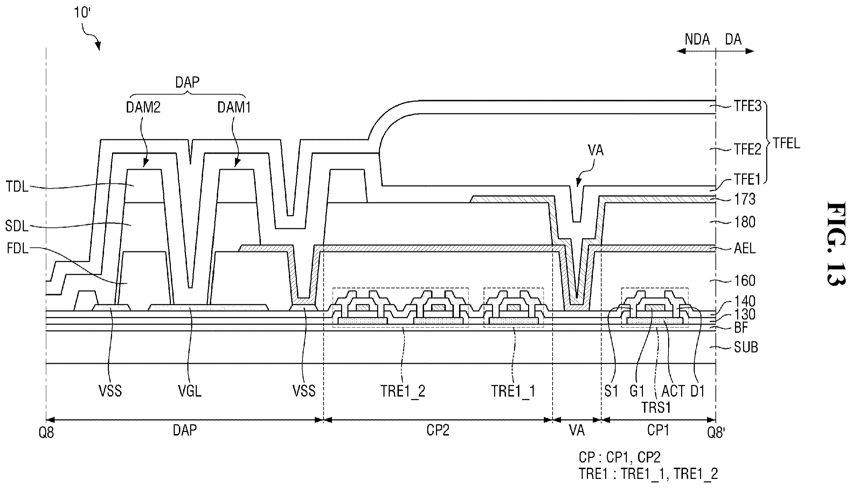

FIG. 10 is a plan view of a non-display area of a display device according to an embodiment. FIG. 11 is a cross-sectional view taken along line Q6-Q6' of FIG. 10. FIG. 12 is a cross-sectional view taken along line Q7-Q7' of FIG. 10. FIG. 13 is a cross-sectional view taken along line Q8-Q8' of FIG. 10.

Referring to FIGS 10 through 13, the current embodiment is different from the above-described embodiment of FIGS. 6 through 9 in that a plurality of openings OP of a pixel defining layer 180 overlap transistors of circuit parts CP in an area overlapping a common electrode 173. A description of the same elements as those of the above-described embodiment will be omitted or given briefly, and differences will be described below.

The circuit parts CP, a groove part VA, and a dam part DAP may be disposed on a substrate SUB in the non-display area NDA of the display device 10'.

Specifically, a plurality of transistors TRS1 and TRE1 may be disposed in the circuit parts CP. A first circuit transistor TRS1 may be disposed in a first circuit part CP1, and a second circuit transistor TRE1 may be disposed in a second circuit part CP2. A via layer 160 covering the first circuit transistor TRS1 and the second circuit transistor TRE1 may be disposed on the circuit parts CP, and a connection line AEL may be disposed on the via layer 160. The connection line AEL may extend from a display area DA to the non-display area NDA and may overlap the first circuit transistor TRS1 and the second circuit transistor TRE1 disposed under the via layer 160.

The pixel defining layer 180 may be disposed on the via layer 160 and the connection line AEL, and the common electrode 173 may be disposed on the pixel defining layer 180. The common electrode 173 may extend from the display area DA to the non-display area NDA. For example, the common electrode 173 may be disposed on the first circuit part CP1, the groove part VA, and the second circuit part CP2. The common electrode 173 may extend to at least a portion of the second circuit part CP2.

The common electrode 173 may overlap the entire first circuit part CP1 and may overlap at least a portion of the second circuit part CP2. For example, the common electrode 173 may overlap a plurality of first transistors TRS1 disposed in the first circuit part CP1. In addition, the common electrode 173 may overlap at least some of a plurality of second transistors TRE1 disposed in the second circuit part CP2.

The second circuit part CP2 may include (2-1)^{th} circuit transistors TRE1_1 adjacent to the first circuit part CP1 and (2-2)^{th} circuit transistors TRE1_2 disposed adjacent to an outer side of the substrate SUB from the (2-1)^{th} circuit transistors TRE1_1. The common electrode 173 may overlap the (2-1)^{th} circuit transistors TRE1_1 and may not overlap the (2-2)^{th} circuit transistors TRE1_2.

The pixel defining layer 180 may include a plurality of openings OP. The openings OP may be disposed in the circuit parts CP. For example, the openings OP may be disposed in the first circuit part CP1 and the second circuit part CP2. The openings OP may be irregularly disposed in plan view. For example, at least some of the openings OP may be disposed at equal intervals in the first direction DR1 and the second direction DR2 in plan view, and other openings OP may be disposed at different intervals in the first direction DR1 or the second direction DR2.

In an embodiment, the openings OP may overlap some circuit transistors overlapping the common electrode 173 among the circuit transistors TRS1 and TRE1 disposed in the circuit parts CP and may not overlap other circuit transistors not overlapping the common electrode 173. Specifically, the openings OP may overlap at least some of the first circuit transistors TRS1 disposed in the first circuit part CP1 and may not overlap the other first circuit transistors TRS1. For example, the openings OP may be disposed at predetermined intervals in consideration of a process margin. Here, when a first circuit transistor TRS1 is disposed in a gap between the openings OP, the openings OP and the first circuit transistor TRS1 may not overlap each other as illustrated in FIG. 13. The other first circuit transistors TRS1 may overlap the openings OP as illustrated in FIGS. 11 and 12.

In addition, the openings OP may overlap some circuit transistors overlapping the common electrode 173 among the second circuit transistors TRE1 disposed in the second circuit part CP2 and may not overlap other circuit transistors not overlapping the common electrode 173. For example, the openings OP may overlap some of the (2-1)^{th} circuit transistors TRE1_1 overlapping the common electrode 173. As described above, when some (2-1)^{th} circuit transistors TRE1_1 are disposed in gaps between the openings OP, the openings OP and the (2-1)^{th} circuit transistors TRE1_1 may not overlap each other. In addition, the openings OP may not overlap the (2-2)^{th} circuit transistors TRE1_2 disposed in the second circuit part CP2.

The common electrode 173 may include a metal material to reflect at least some light. For example, since the common electrode 173 covers the circuit parts CP, it can prevent at least a portion of light incident from the outside from entering the circuit parts CP. Therefore, relatively little external light may be incident on circuit transistors TRS1 and TRE1 of the circuit parts CP which overlap the common electrode 173. Accordingly, even when the openings OP of the pixel defining layer 180 and the circuit transistors TRS1 and TRE1 overlap, deterioration of the circuit transistors TRS1 and TRE1 due to external light can be reduced.

On the other hand, external light may be directly incident on circuit transistors TRE1 (i.e., the (2-2)^{th} circuit transistors TRE1_2) not overlapping the common electrode 173. Therefore, these circuit transistors TRE1 may be disposed not to overlap the openings OP. That is, since the (2-2)^{th} circuit transistors TRE1_2 overlap the black pixel defining layer 180, their deterioration due to external light can be prevented.

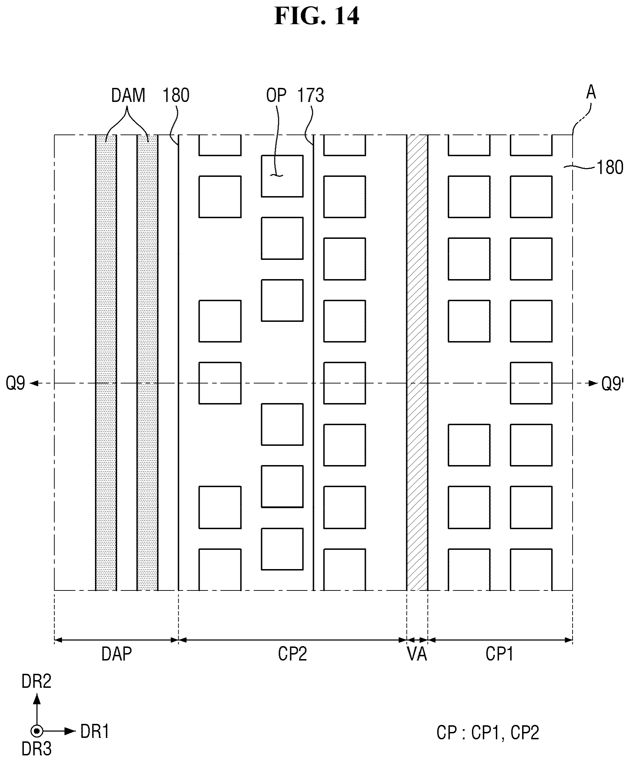

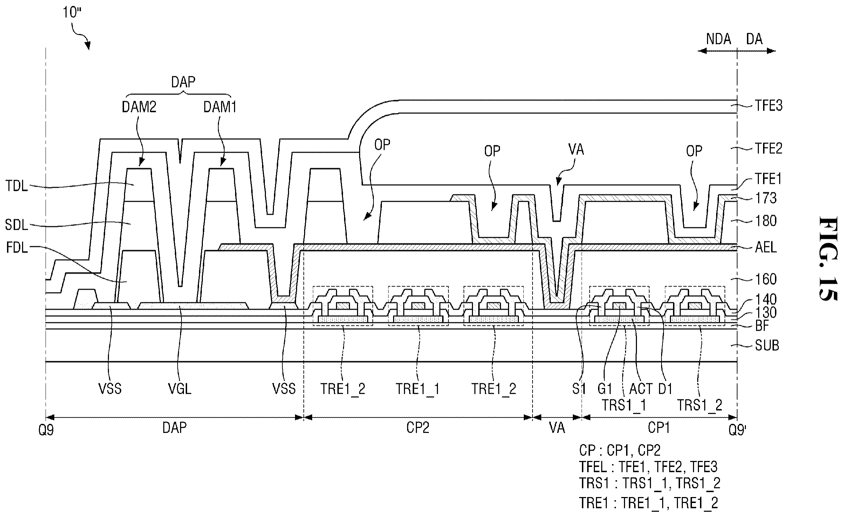

FIG. 14 is a plan view of a non-display area of a display device according to an embodiment. FIG. 15 is a cross-sectional view taken along line Q9-Q9' of FIG. 14.

Referring to FIGS. 14 and 15, the current embodiment is different from the above-described embodiments of FIGS. 6 through 13 in that buffer transistors among circuit transistors TRS1 and TRE1 of circuit parts CP do not overlap a plurality of openings OP of a pixel defining layer 180. A description of the same elements as those of the above-described embodiments will be omitted or given briefly, and differences will be described below.

The circuit parts CP, a groove part VA, and a dam part DAP may be disposed on a substrate SUB in the non-display area NDA of the display device 10".

Specifically, a plurality of transistors TRS1 and TRE1 may be disposed in the circuit parts CP. First circuit transistors TRS1 may be disposed in a first circuit part CP1, and second circuit transistors TRE1 may be disposed in a second circuit part CP2.

The first circuit part CP1 may include (1-1)^{th} circuit transistors TRS1_1 and (1-2)^{th} circuit transistors TRS1_2. The (1-1)^{th} circuit transistors TRS1_1 may be buffer transistors. The buffer transistors may equally transmit an input voltage and an output voltage in each of the circuit parts CP1 and CP2. The (1-2)^{th} circuit transistors TRS1_2 may be switching transistors other than the buffer transistors.

The second circuit part CP2 may include (2-1)^{th} circuit transistors TRE1_1 and (2-2)^{th} circuit transistors TRE1_2. The (2-1)^{th} circuit transistors TRE1_1 may be buffer transistors. The (2-2)^{th} circuit transistors TRE1_2 may be switching transistors other than the buffer transistors.

The (1-1)^{th} circuit transistors TRS1_1 and the (2-1)^{th} circuit transistors TRE1_1 may have a relatively larger active layer ACT than the (1-2)^{th} circuit transistors TRS1_2 and the (2-2)^{th} circuit transistors TRE1_2. That is, since the (1-1)^{th} circuit transistors TRS1_1 and the (2-1)^{th} circuit transistors TRE1_1 have a large active layer ACT, their deterioration due to external light may be more fatal.

In the current embodiment, the (1-1)^{th} circuit transistors TRS1_1 and the (2-1)^{th} circuit transistors TRE1_1 in the circuit parts CP1 and CP2 are disposed not to overlap the openings OP of the pixel defining layer 180. Therefore, the (1-1)^{th} circuit transistors TRS1_1 and the (2-1)^{th} circuit transistors TRE1_1 can be prevented from being deteriorated by external light.

Specifically, in the first circuit part CP1, the (1-1)^{th} circuit transistors TRS1_1 may overlap the pixel defining layer 180, and the black pixel defining layer 180 may prevent external light from entering the (1-1)^{th} circuit transistors TRS1_1. The (1-2)^{th} circuit transistors TRS1_2 may overlap the openings OP of the pixel defining layer 180.

The (1-1)^{th} circuit transistors TRS1_1 and the (1-2)^{th} circuit transistors TRS1_2 disposed in the first circuit part CP1 may overlap a common electrode 173. Since the (1-1)^{th} circuit transistors TRS1_1 overlap the common electrode 173 and the pixel defining layer 180, their active layers ACT can be prevented from being deteriorated by external light. The (1-2)^{th} circuit transistors TRS1_2 overlapping the openings OP are blocked from at least a portion of external light by the common electrode 173. Thus, deterioration of their active layers ACT by the external light can be reduced.

In the second circuit part CP2, the (2-1)^{th} circuit transistors TRE1_1 may overlap the pixel defining layer 180, and the black pixel defining layer 180 may prevent external light from entering the (2-1)^{th} circuit transistors TRE1_1. Therefore, since the (2-1)^{th} circuit transistors TRE1_1 overlap the pixel defining layer 180, their active layers ACT can be prevented from being deteriorated by external light.

The (2-2)^{th} circuit transistors TRE1_2 may overlap the openings OP of the pixel defining layer 180. At least some of the (2-2)^{th} circuit transistors TRE1_2 may overlap the common electrode 173. That is, the (2-2)^{th} circuit transistors TRE1_2 may overlap the common electrode 173 and the openings OP. The (2-2)^{th} circuit transistors TRE1_2 overlapping the openings OP are blocked from at least a portion of external light by the common electrode 173. Thus, deterioration of their active layers ACT by the external light can be reduced.

Although the embodiments of the present invention have been described above with reference to the accompanying drawings, it will be understood by those of ordinary skill in the art to which the present invention pertains that the present invention may be embodied in other specific forms without changing the technical spirit or essential characteristics of the present invention. Therefore, the embodiments described above are to be understood as illustrative in all respects and not restrictive.

## Claims

1. A display device comprising:
a substrate comprising a display area and a non-display area;
a light emitting element layer disposed on the display area and comprising a pixel electrode, an organic light emitting layer and a common electrode;
a circuit part disposed on the non-display area and comprising a plurality of circuit transistors; and
a pixel defining layer extending from the display area to the circuit part,
wherein the pixel defining layer comprises a plurality of openings overlapping the circuit part, and the openings do not overlap the circuit transistors.

2. The display device of claim 1, wherein the pixel defining layer covers edges of the pixel electrode and comprises a black pigment or dye.

3. The display device of claim 1, wherein circuit transistors not overlapping the openings among the circuit transistors overlap the pixel defining layer.

4. The display device of claim 1, wherein a distance between any two adjacent openings among the openings is different from a distance between two other openings.

5. The display device of claim 1, wherein a distance between any two adjacent openings among the openings is greater than a distance between two other openings.

6. The display device of claim 1, wherein the circuit transistors comprise an oxide semiconductor.

7. The display device of claim 1, further comprising a via layer disposed on the display area and the non-display area and disposed between the substrate and the pixel defining layer,
wherein the openings expose an upper surface of the via layer.

8. The display device of claim 1, wherein the common electrode extends from the display area to the circuit part and overlaps at least some of the circuit transistors.

9. A display device comprising:
a substrate comprising a display area and a non-display area;
a light emitting element layer disposed on the display area and comprising a pixel electrode, an organic light emitting layer and a common electrode;
circuit parts disposed on the non-display area and comprising a plurality of circuit transistors; and
a pixel defining layer extending from the display area to the circuit parts,
wherein the common electrode extends from the display area to the circuit parts, the pixel defining layer comprises a plurality of openings overlapping the circuit parts, some of the circuit transistors overlap the common electrode, and the openings overlap at least some of the circuit transistors overlapping the common electrode and do not overlap circuit transistors not overlapping the common electrode.

10. The display device of claim 9, wherein the circuit parts comprise a first circuit part disposed adjacent to the display area and a second circuit part spaced farther apart from the display area than the first circuit part,
wherein the first circuit part comprises a plurality of first circuit transistors, and the common electrode overlaps the first circuit transistors.

11. The display device of claim 10, wherein the second circuit part comprises (2-1)th circuit transistors adjacent to the first circuit part and (2-2)th circuit transistors disposed adjacent to an outer side of the substrate from the (2-1)^{th} circuit transistors, and
the common electrode overlaps the (2-1)th circuit transistors and does not overlap the (2-2)th circuit transistors.

12. The display device of claim 11, wherein the openings overlap at least some of the first circuit transistors and overlap at least some of the (2-1)-th circuit transistors.

13. The display device of claim 12, wherein the openings do not overlap the (2-2)th circuit transistors.

14. A display device comprising:
a substrate comprising a display area and a non-display area;
a light emitting element layer disposed on the display area and comprising a pixel electrode, an organic light emitting layer and a common electrode;
circuit parts disposed on the non-display area and comprising a plurality of circuit transistors; and
a pixel defining layer extending from the display area to the circuit parts and comprising a plurality of openings overlapping the circuit parts,
wherein the openings overlap at least some of the circuit transistors and do not overlap the other circuit transistors.

15. The display device of claim 14, wherein the circuit parts comprise a first circuit part disposed adjacent to the display area and a second circuit part spaced farther apart from the display area than the first circuit part,
wherein each of the first circuit part and the second circuit part comprises at least buffer transistors, and the buffer transistors do not overlap the openings.

16. The display device of claim 15, wherein each of the first circuit part and the second circuit part further comprises switching transistors, and at least some of the switching transistors overlap the openings, and the other switching transistors overlap the pixel defining layer.

17. The display device of claim 15, wherein the common electrode extends from the display area to the circuit parts, overlaps the first circuit part and the second circuit part, the buffer transistors disposed in the first circuit part overlap the common electrode, and at least some of the buffer transistors disposed in the second circuit part do not overlap the common electrode.

18. The display device of claim 14, wherein the circuit transistors comprise an oxide semiconductor.

19. The display device of claim 14, further comprising:
a via layer disposed between the substrate and the pixel defining layer and covering the circuit transistors; and
a connection line disposed between the pixel defining layer and the via layer and overlapping the circuit transistors.

20. The display device of claim 14, further comprising a thin-film encapsulation layer disposed on the light emitting element layer and extending from the display area to the non-display area,
wherein the thin-film encapsulation layer overlaps the circuit transistors.
